# EUROPÄISCHE PATENTSCHRIFT

(11) **EP 2 373 828 B1**
(45) Veröffentlichungstag und Bekanntmachung des Hinweises auf die Patenterteilung: **12.11.2014**
(21) Anmeldenummer: 09807664.9
(22) Anmeldetag: 04.12.2009
(51) Int. Cl.: C23C 14/35, C23C 14/56

(54) **VORRICHTUNG ZUR OBERFLÄCHENBEHANDLUNG UND/ODER -BESCHICHTUNG VON SUBSTRATKOMPONENTEN**
APPARATUS FOR TREATING AND/OR COATING THE SURFACE OF A SUBSTRATE COMPONENT
DISPOSITIF DE TRAITEMENT ET/OU DE REVÊTEMENT DE SURFACE DE COMPOSANTS DE SUBSTRAT

(30) Priorität: 15.12.2008 DE 102008062332
(43) Veröffentlichungstag der Anmeldung: 12.10.2011
(73) Patentinhaber: Gühring OHG, 72458 Albstadt (DE)
(72) Erfinder: FIEDLER, Mario, 13125 Berlin (DE)
(74) Vertreter: Winter, Brandl, Fürniss, Hübner, Röss, Kaiser, Polte - Partnerschaft mbB
(86) Internationale Anmeldenummer: PCT/DE2009/001712
(87) Internationale Veröffentlichungsnummer: WO 2010/069289

(56) Entgegenhaltungen:
- WO-A1-2008/013469
- GB-A- 2 303 380
- US-A- 6 054 029

## Beschreibung

Die Erfindung betrifft eine Vorrichtung und ein Verfahren zur Oberflächenbehandlung und/oder -beschichtung von Substratkomponenten durch Abscheidung aus der Gasphase, insbesondere durch physikalische Abscheidung aus der Gasphase nach dem PVD- (Physical Vapour Deposition) oder dem reaktiven PVD-Verfahren, gemäß dem Oberbegriff des Patentanspruchs 1 bzw. des Patentanspruchs 14. Mit derartigen Verfahren bzw. mit solchen Vorrichtungen gelingt es, auf Werkstückoberflächen, d.h. auf Substratkomponenten sehr dünne Schichten, beispielsweise Korrosions- oder Verschleißschutzschichten, wie z. B. Hartstoffschichten beispielsweise auf Titanbasis, aufzubringen. Derartige Dünnschichten finden häufig bei der Werkzeugproduktion, insbesondere bei der Produktion von spanabhebenden Präzisionswerkzeugen, wie z. B. Bohr-, Fräs- oder Reibwerkzeugen Anwendung.

Während beim CVD- (Chemical Vapour Deposition) Verfahren mit verhältnismäßig hohen Prozesstemperaturen von 900 bis 1100°C gearbeitet wird, können beim PVD-Prozess die Prozesstemperaturen wesentlich niedriger, d.h. bei etwa 100 bis 600°C liegen. Nach diesem Verfahren wird der Beschichtungswerkstoff zunächst durch Anwendung eines geeigneten physikalischen Effekte, wie z. B. durch einen Elektronenstrahl, einen Lichtbogen (Arc-PVD) oder durch Kathodenzerstäubung verdampft. Das verdampfte Material trifft dann auf die Substratoberfläche auf, wo es zur Schichtbildung kommt. Damit die Dampfteilchen das Substrat erreichen, muß mit Unterdruck gearbeitet werden. Bei diesem Prozess liegt eine geradlinige Teilchenbewegung vor, so dass das Substrat bewegt werden muß, damit die gesamte Substratoberfläche gleichmäßig und homogen beschichtet werden kann.

Die beim PVD-Verfahren niedrigeren Prozesstemperaturen werden allerdings mit einem größeren vorrichtungstechnischen Aufwand erkauft. Denn die zu beschichtenden Substrate müssen - um zu einer guten Schichthaftung zu gelangen - einer sorgfältigen Oberflächenvorbehandlung und einer genauen Prozessführung unterworfen werden. Darüber hinaus muss dafür gesorgt werden, dass sogenannte Abschattungseffekte kompensiert werden. Deshalb müssen einschlägige PVD-Beschichtungsanlagen mit einer Antriebstechnik zur kontinuierlichen Bewegung der Substratkomponenten während des Beschichtungs- bzw. Oberflächenbehandlungsvorgangs ausgestattet werden. Weil das Auf- oder Bedampfen darüber hinaus im Hochvakuum, d.h. im Bereich von 10⁻⁴ bis 10 Pa, erfolgt, die Behandlungskammer also hermetisch nach außen abgeschlossen werden muss, ergibt sich hierdurch ein verhältnismäßig komplexer Aufbau der Beschichtungsanlage.

Um die Beschichtungsmaterialien, wie z.B. Metalle in die Gasphase überzuführen, werden nach dem PVD-Verfahren verschiedene Wege eingeschlagen, wie z.B. das Kathodenzerstäuben bzw. das Sputtern, einschließlich des Magnetron-Sputterns, das Ionenplattieren, einschließlich des reaktiven Ionenplattierens, oder das das Laserverdampfen oder das Vakuumverdampfen. Allen Verfahren ist gemeinsam, dass zur Erzielung des gewünschten Beschichtungs- bzw. Behandlungseffekts die Prozessparameter wie Gasatmosphäre, Temperatur und Ausrichtung der Substratoberfläche zum Beschichtungsmaterial sehr genau eingehalten werden müssen. Deshalb sind herkömmliche Beschichtungsanlagen so aufgebaut worden, dass die Behandlungskammer Platz für mehrere Substratträger und Beschichtungs- und/oder Behandlungseinheiten wie z. B. Verdampferquellen, Kathoden, Targets, Magnetrons, usw., bietet. Solche Vakuumbehandlungsanlagen sind z. B. in der DE 10 2005 050 358 A1 oder in der DE 10 2006 020 004 A1 beschrieben.

Mit solchen marktüblichen Anlagen können die zu beschichtenden bzw. zu behandelnden Substrate mit nur einer einzigen Schichtart versehen werden. Auch wenn diese Schichtart eine mehrlagige Schicht ist, wie sie beispielsweise im Dokument US 6,051,113 beschrieben ist, bedeutet dies für herkömmliche Beschichtungsanlagen, dass über die gesamte Charge der Beschichtungsanlagen immer nur eine Schichtart abgeschieden werden kann, auch wenn sich die Schichtdicke über die gesamte Charge unterschiedlich verhalten kann.

Dies führt dazu, dass herkömmliche Beschichtungsanlagen, oftmals nur unwirtschaftlich betrieben werden können. Denn die prozentual meiste Prozesszeit bei den eingangs beschriebenen Beschichtungs- und/oder Behandlungsanlagen nach dem PVD-Verfahren wird beim Aufheizen und Abkühlen der Substrate und deren Haltevorrichtungen verbraucht. Weil darüber hinaus bei vielen Beschichtungs-Zentren das Spektrum der zu beschichtenden Substratkomponenten breit gefächert ist, werden für die unterschiedlichen Substratkomponenten auch unterschiedliche Schichten verlangt. Da das Volumen der Beschichtungsanlage aufgrund der Abmessungen des Beschichtungskessels feststeht, die Anzahl der Substrate bzw. Substratkomponenten, die eine bestimmte Schichtart verlangen, oftmals nicht ausreicht, um eine Beschichtungsanlage zu 100% zu füllen, können letztlich die geforderten Lieferzeiten nicht eingehalten werden.

Das Dokument GB 2 303 380 A offenbart eine Sputter-Vorrichtung zur Oberflächenbehandlung und/oder -beschichtung von Substratkomponenten nach dem PVD-Verfahren mit einer Abscheidungs- bzw. Behandlungskammer, in der mehrere Substrate und mehrere Beschichtungs- oder Behandlungseinheiten angeordnet sind. Durch die Anwendung von Trennwänden kann die Vorrichtung einen modularen Aufbau aufweisen. Durch Änderung derBehandlungsdauer, der Leistung des Magnetrons oder der BIAS-Spannung ist es möglich, die Substrate einer Charge einer unterschiedlichen Behandlung zu unterziehen. Allerdings bleibt die Flexibilität des Einsatzes dieser bekannten Vorrichtung begrenzt, weil in den voneinander abgetrennten Kammerabschnitten voneinander unabhängig oder gleichzeitig keine unterschiedlichen Behandlungen der Substrate vorgenommen werden können.

Der Erfindung liegt deshalb eine Vorrichtung zur Oberflächenbehandlung und/oder -beschichtung von Substratkomponenten durch Abscheidung aus der Gasphase, insbesondere durch physikalische Abscheidung aus der Gasphase nach dem PVD-Verfahren, sowie ein Verfahren zum Betreiben einer derartigen Vorrichtung bereitzustellen, mit der bzw. mit dem es gelingt, die Prozess- und Lieferzeiten zu minimieren.

Diese Aufgabe wird hinsichtlich der Vorrichtung durch die Merkmale des Anspruchs 1 und hinsichtlich des Verfahrens durch die Verfahrensschritte des Anspruchs 13 gelöst, wobei es gelingt, die Prozesszeiten zusätzlich dadurch zu verkürzen, dass verschiedene Behandlungen der Substratkomponenten gleichzeitig ablaufen können.

Erfindungsgemäß wird die Vorrichtung so aufgebaut, dass sie mit Modulen bestückt werden kann, und zwar derart, dass die in einer Charge in die

Beschichtungsvorrichtung eingebrachten Substratkomponenten nach dem Schließen des Beschichtungs-/Behandlungsraums einer unterschiedlichen Behandlung, d.h. einer Beschichtung oder einer Oberflächenbehandlung, unterzogen werden können. Durch die erfindungsgemäße Gestaltung der Vorrichtung den Auslastungsgrad der Beschichtungsanlage erheblich zu steigern und darüber hinaus die Beschichtungsanlage wesentlich wirtschaftlicher und mit stark verbesserter Energieeffizienz zu betreiben. Denn die erfindungsgemäß größere Anzahl von Substratkomponenten in der Beschichtungsanlage ist nur einmal aufzuheizen und abzukühlen, wodurch Prozesszeit in erheblichem Umfang eingespart wird.

Das erfindungsgemäße Verfahren ist im Kern dadurch gekennzeichnet, dass Beschichtungs- und/oder Behandlungseinheiten sowie Abschirmmodule entsprechend einem gewünschten Beschichtungs- und/oder Behandlungsprogramm für unterschiedlich zu beschichtende Substratkomponenten zusammengestellt werden, und dass dann die Substratträger mit denjenigen Substratkomponenten bestückt werden, die in einer Charge derselben Behandlung unterzogen werden sollen. Nach dem Schließen der Behandlungskammer sorgen dann die Abschirmmodule und die Prozesssteuerung der Anlage dafür, dass die auf den einzelnen Substratträgern zusammengefassten Substratkomponenten einem individuellen Beschichtungs- und/oder Behandlungsprogramm unterzogen werden. Dabei kann gemäß einer Weiterbildung des Verfahrens eine unterschiedliche Behandlung der Substratkomponenten an verschiedenen Orten der Beschichtungskammer sogar gleichzeitig erfolgen.

Aufgrund des modularen Aufbaus der Anlage ist es möglich, die Beschichtungsanlage äußerst flexibel an die jeweils vorliegende Auftragslage anzupassen. Dabei ergibt sich der zusätzliche Vorteil, dass die Anlage selbst dann, wenn nur eine Mindermenge chargiert wird, wirtschaftlich betrieben werden kann, indem innerhalb der Behandlungskammer Bereiche geschaffen werden können, die individuell und abgeschirmt von anderen Bereichen der Behandlungskammer aufgeheizt und abgekühlt werden können und in denen unter Abschirmung von weiteren Bereichen der Kammer ein bestimmtes Beschichtungs- und/oder Ätzprogramm durchgeführt werden kann.

Dabei wird erfindungsgemäß der vorhandene Bauraum der Behandlungskammer in vorteilhafter Weise ausgenutzt, wobei sich der zusätzliche Vorteil ergibt, dass die unterschiedlichen Behandlungen der Substratkomponenten aufgrund der räumlichen Trennung der Behandlungsstationen gleichzeitig ablaufen können. Außerdem wird dadurch die Möglichkeit eröffnet, unterschiedliche Substratträger vor ausgewählten Beschichtungs- und/oder Behandlungseinheiten einer individuellen Behandlung mit genau kontrollierten Prozessparametern zu unterziehen, ohne durch benachbarte Beschichtungs- und/oder Behandlungseinheiten beeinflusst zu werden. Dadurch gelingt es, eine sehr genaue und homogene Aufwachsrate der Schicht zu erzielen.

Durch die Abschirmeinrichtung nach Anspruch 2, die vorzugsweise wiederum als Modul ausgebildet wird, gelingt es, wertvollen Baumraum einzusparen, denn mittels der Abschirmmodule lassen sich Substratkomponenten selbst auf engstem Bauraum einer unterschiedlichen Behandlung unterziehen.

Es hat sich gezeigt, dass es für PVD-Beschichtungsanlagen ohne weiteres genügt, die Abschirmmodule in Form einer Trennwandkonfiguration nach Anspruch 3 auszubilden, ohne eine Qualitätsminderung der Oberflächenbehandlung bzw. -beschichtung in Kauf nehmen zu müssen. Die Trennwände können aus unterschiedlichem Material bestehen, einschließlich Keramik- und/oder Lochblechmaterial.

Die Flexibilität der Anlage wird dadurch zusätzlich gesteigert, wenn gemäß Anspruch 4 eine Kinematik vorgesehen wird, mit der die Relativlage zwischen den Substratträgern und den Beschichtungs- und/oder Behandlungseinheiten und/oder Heizeinrichtungen bei geschlossener Abscheidungs- bzw. Behandlungskammer verändert werden kann.

Es ist grundsätzlich möglich, die Beschichtungs- und/oder Behandlungseinheiten zusammen mit der Trägerkonstruktion mit einem Antrieb zu versehen. Die Kinematik wird jedoch einfacher, wenn ein Montagetisch gemäß Anspruch 8 mit einem Drehantrieb ausgestattet wird.

Vorteilhafterweise wird die Drehantriebseinrichtung für den Montagetisch gleichzeitig als Indexiereinrichtung zur Positionierung ausgewählter Substratträger gegenüber ausgewählten Beschichtungs- und/oder Behandlungseinheiten herangezogen, wodurch der steuerungstechnische Aufwand kleiner wird.

Vorteilhafterweise ist - vorzugsweise in Verbindung mit der Ausgestaltung gemäß Anspruch 9 - an jedem Montageplatz des Montagetischs ein Drehantrieb, beispielsweise in Form einer Welle, für einen Substratträger vorgesehen. Es ist auf diese Weise möglich, die Beschichtungsanlage bei 100%iger Füllung mit gleichmäßig zu beschichtenden Substratelementen auf herkömmliche Weise zu betreiben, ohne die vorstehend beschriebene Flexibilität der Anlage zu verlieren.

Mit der Modifikation des Anspruchs 10 kann z.B. ein ausgewählter Substratträger in unmittelbarer Nachbarschaft zu einer Beschichtungs- und/oder Behandlungseinheit in Drehbewegung versetzt werden, ohne den Taktbetrieb zu betätigen, wodurch es gelingt, auf diesen ausgewählten Substratkomponenten eine äußerst homogene und in ihrer Dicke genau definierte Schicht abzuscheiden.

Grundsätzlich ist es möglich, ausgewählte Beschichtungs- und/oder Behandlungseinheiten nacheinander in Funktion zu setzen. Der erfindungsgemäße Aufbau der Beschichtungsanlage erlaubt es jedoch auch, ausgewählte Beschichtungs- und/oder Behandlungseinheiten synchron zu betreiben, wodurch weitere Prozesszeit eingespart wird.

Nachstehend werden anhand schematischer Zeichnungen Ausführungsbeispiele der Erfindung näher erläutert. Es zeigen:
Fig. 1 eine perspektivische Ansicht des Innenraums einer Beschichtungsanlage bei abgenommener Beschichtungskammerwandung;
Fig. 2 schematisch die Draufsicht der Beschichtungsanlage gemäß Fig. 1 bei geschlossener Beschichtungskammer;
Fig. 3 eine schematische Schnittansicht der Beschichtungsanlage gemäß Fig. 2 bei einer Schnittführung entsprechend III-III in Fig. 2;
Fig. 4 eine perspektivische schematische Ansicht ausgewählter Antriebskomponenten der erfindungsgemäßen Beschichtungsanlage; und
Fig. 5A bis 5D Schaubilder zur Darstellung unterschiedlicher Montagetisch-Positionen bei der Durchführung des erfindungsgemäßen Verfahrens.

In den Figuren sind schematisch die im Inneren einer nicht näher dargestellten Prozesskammer einer Beschichtungsanlage aufgenommen Komponenten dargestellt, die zur Beschichtung von Substratkomponenten nach dem PVD-Verfahren bzw. nach dem reaktiven PVD-Verfahren benötigt werden. Mit anderen Worten, die in den Figuren gezeigten Baugruppen sind in einer evakuierbaren und vorzugsweise mit verschiedenen Gasanschlüssen versehenen Beschichtungskammer bzw. Vakuumkammer angeordnet. Derartige Vakuumkammern sind bekannt, sodass auf eine genaue Beschreibung dieser Kammer hier verzichtet werden kann. Die Besonderheit der nachfolgend näher zu beschreibenden Beschichtungsanlage besteht darin, wie das Innere der evakuierbaren Abscheidungs- bzw. Behandlungskammer bestückt werden kann, um die Wirtschaftlichkeit beim Betrieb einer solchen Anlage erheblich anzuheben und aufgrund verbesserter Flexibilität die Prozesszeiten der Anlage zu minimieren.

Zu diesem Zweck wird ein modularer Aufbau der Beschichtungsvorrichtung gewählt. Um einen mit 10 bezeichneten Montagetisch herum sind in vorbestimmten Winkelabständen Beschichtungs- und/oder Behandlungsmodule 12 angeordnet. Diese Beschichtungs- und/oder Behandlungsmodule 12 sind beispielsweise von Verdampfer oder sogenannten Sputter-Kathoden mit modular bestückbaren Targets gebildet, wobei zusätzlich - nicht näher gezeigte - sogenannte Shutter zur Anwendung kommen könnten. Derartige Beschichtungs- bzw. Behandlungsmodule sind an sich bekannt, so dass sich eine genauere Beschreibung dieser Komponenten hier erübrigt. Es soll aber hervorgehoben werden, dass die vorliegende Erfindung nicht auf spezielle Behandlungs-/Beschichtungsmodule beschränkt ist. Es können vielmehr alle beim Beschichtungsprozess nach dem PVD-Verfahren regelmäßig zur Anwendung kommenden Einheiten verwendet werden. Neben den Beschichtungs-/Behandlungsmodulen 12 sind zusätzlich Heizeinheiten 14 vorgesehen, die in der Regel zwischen den Behandlungsmodulen 12 angeordnet sind und ebenfalls als Module ausgeführt sein können.

Im Zentrum des Montagetischs 10 befindet sich eine mit 16 bezeichnete Ätzanode mit einer in den Figuren nicht näher dargestellten zentralen Filamentkathode zusammenwirkt, welche oberhalb der Beschichtungsmodule 12 und Heizeinheiten 14 im Bereich der nicht dargestellten Kuppel der Beschichtungskammer zu liegen.

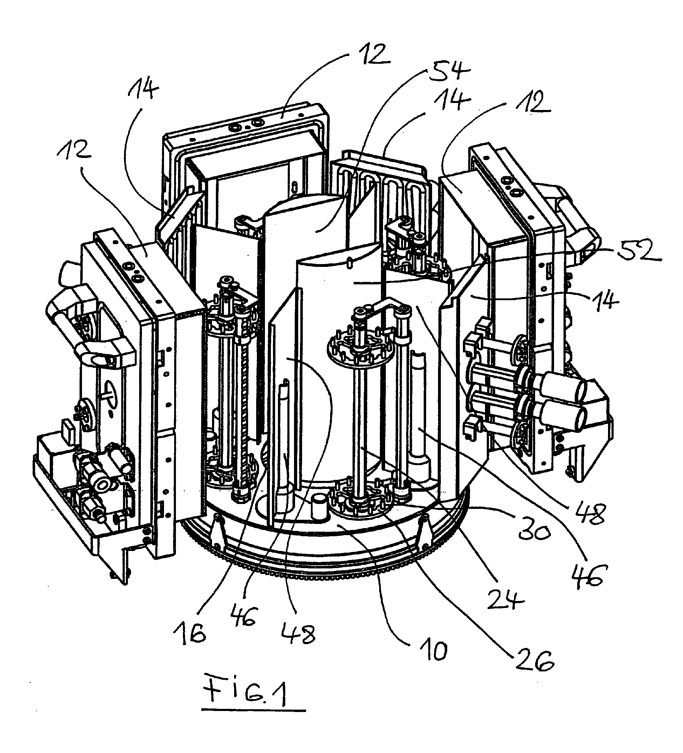

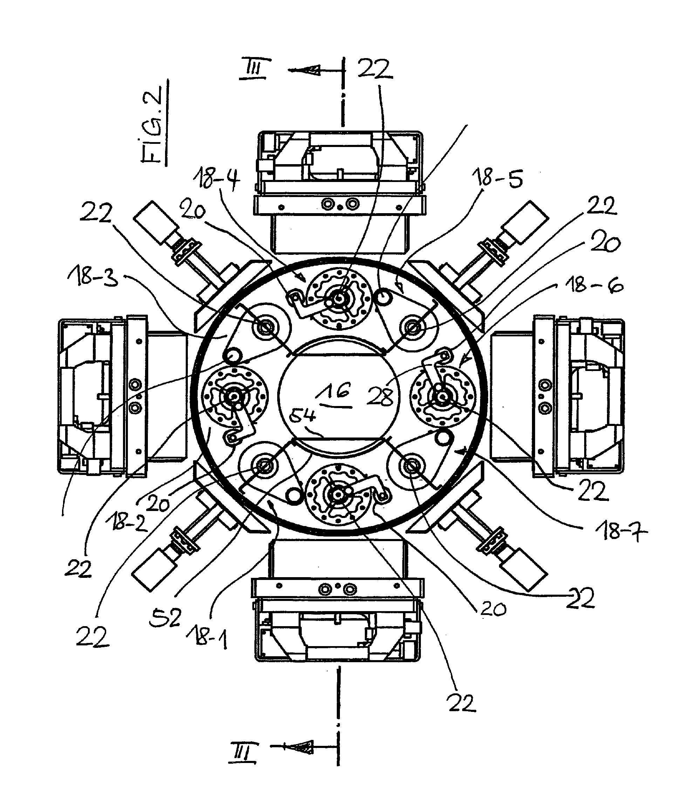

Fig. 1 zeigt die Anordnung der für die Beschichtung bzw. Behandlung erforderlichen Module bei geöffneter Abscheidungs- bzw. Behandlungskammer, während in der Draufsicht gemäß Fig. 2 die Anordnung bei geschlossener Kammer dargestellt ist. Aus dieser Darstellung ergibt sich, dass ein Teil der um den Montagetisch 10 herum gruppierten Beschichtungsmodule 12 und Heizeinheiten 14 an einem gesonderten Bauelement montierbar sind, welches als Beschickungstür für die Vakuumkammer dient. Die übrigen Beschichtungs- und Heizmodule sind an einer Trägerkonstruktion montiert, welche - ebenso wir die Beschickungstüre - Montagestellen zur flexiblen Anordnung der Beschichtungs- und Heizmodule aufweist.

Der Montagetisch 10 ist als eine Art Karussell ausgebildet und er trägt - wie am besten aus der Fig. 2 ersichtlich - mehrere, dass heißt im gezeigten Ausführungsbeispiel 8, vorzugsweise identisch gestaltete Montageplätze 18-1 bis 18-8, die individuell mit unterschiedlichen Modulen bestückbar sind.

Jedem Montageplatz 18-1 bis18-8 ist eine Antriebswelle 22 zugeordnet, die jeweils eine vertikale Drehachse hat. Bei den Montageplätzen 18-2, 18-4, 18-6 und 18-8 ist die Antriebswelle 22 drehfest mit einer vertikalen Trägerwelle 24 gekoppelt, die in vorbestimmten und vorzugsweise einstellbaren Axialabständen Drehteller 26 mit Steck-Aufnahmen 30 zur Halterung von Substratkomponenten, wie z.B. von Bohrwerkzeugen trägt. Die Steck-Aufnahmen sind so ausgeführt, dass die Bohrwerkzeuge mit den zu beschichtenden bzw. zu behandelnden Oberflächenabschnitten aus der Steck-Aufnahme vorstehen.

Mittels einer Stützstange 20 und eines Stützarms 28 wird die Trägerwelle 24 stabilisiert. Über ein nicht näher gezeigtes Getriebe kann dafür gesorgt werden, dass die Steck-Aufnahmen und damit auch die Substratkomponenten bei Drehung der Drehteller 26 eine gleich- oder gegengerichtete Eigendrehung um die ebenfalls vertikale Achse der Steck-Aufnahme ausführen.

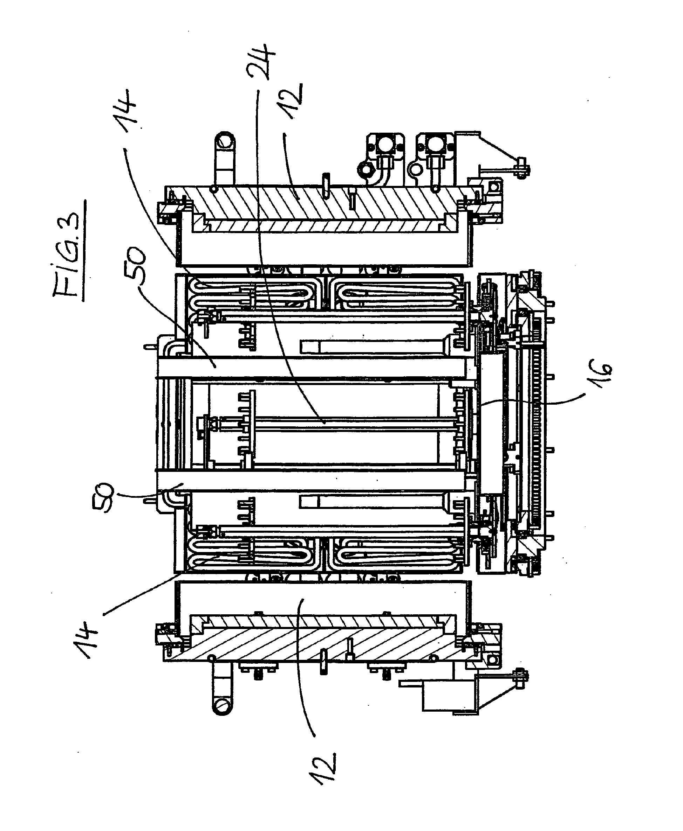

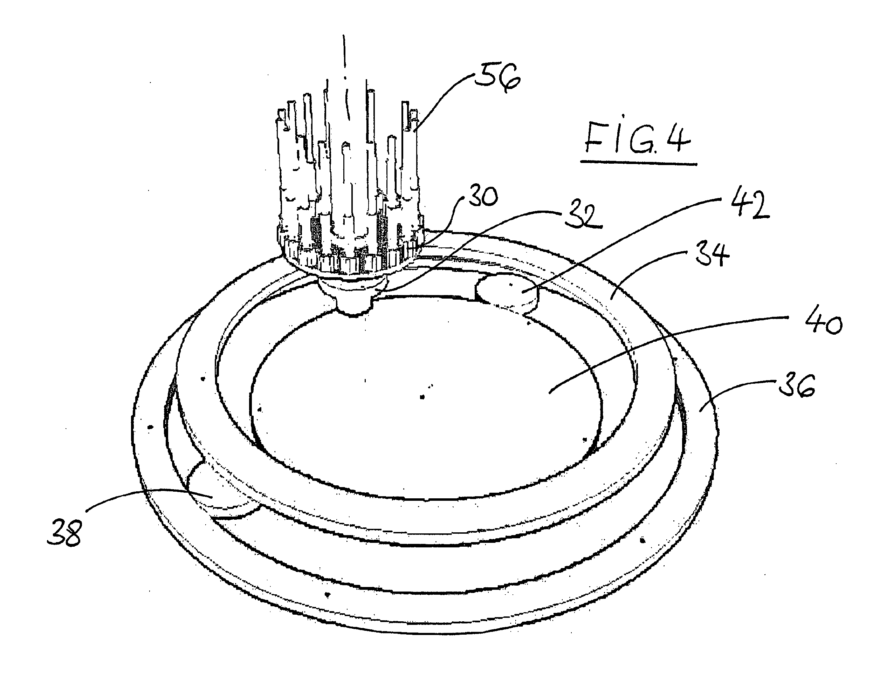

In Figur 4 ist schematisch anhand einer von der Darstellung der Figuren 1 bis 3 etwas abgewandelten Kinematik angedeutet, wie die Drehbewegung auf den Montagetisch 10 und die Antriebswellen 22 übertragen werden kann. Unterhalb des Montagetischs 10 befindet sich ein Antriebszahnrad 32, das in Kämmeingriff mit der Innenverzahnung eines ersten Ringrads 34 steht. Das Ringrad 34 ist drehfest mit einem axial versetzten, im Durchmesser größeren zweiten Ringrad 36 verbunden, das über seine Innenverzahnung mittels eines ersten Antriebsritzels 38 angetrieben werden kann.

Die das Antriebszahnrad 32 tragende Welle 22 erstreckt sich drehbar gelagert durch den Montagetisch 10 hindurch und sitzt drehbar in einem ebenfalls unterhalb des Montagetischs 10 liegenden Zahnrad 40, das über ein zweites Antriebsritzel 42 antreibbar ist.

Wenn somit das zweite Antriebsritzel 42 angetrieben wird, nimmt das Zahnrad 40 die Antriebswellen 22 und damit den Montagetisch 10 in Drehrichtung mit. Auf diese Weise kann der Montagetisch 10 getaktet werden.

Gleichzeitig wälzen die Antriebszahnräder 32 an der Innenverzahnung des ersten Ringrads 34 ab. Durch geeignete Steuerung des Drehantriebs des ersten Antriebsritzels 38 kann die Drehzahl des ersten Ringrads 34 ebenso groß wie die Drehzahl des Zahnrads 40 gehalten werden, so dass während der Taktbewegung des Montagetischs 10 eine Drehung der Antriebswellen 22 unterbleibt.

Wenn demgegenüber der Antrieb des zweiten Antriebsritzels 42 angehalten wird und der Montagetisch indexiert bleibt, können durch Ansteuerung des ersten Antriebsritzels38 alle Antriebswellen 22 gleichzeitig in Drehbewegung versetzt werden.

Einige der Montageplätze, d.h. die Montageplätze 18-1, 18-3, 18-5 und 18-7 sind unterschiedlich zu den Montageplätzen 18-2, 18-4, 18-6 und 18-8 bestückt. Sie tragen eine Abdeckplatte 44, die oberhalb der abgedeckten Antriebswelle 22 eine Halterung 46 für ein radial ausgerichtetes Abschirmblech 48 aufweist. Zwischen den beiden benachbarten Abschirmblechen 48 der Montageplätze 18-1 und 18-7 bzw. 18-3 und 18-5 ist jeweils eine weitere, stationär montierte Abschirmwandanordnung 50 vorgesehen, die jeweils von einem konvexen Blech 52 und einem Sekantenblech 54 gebildet ist und die den Raum zwischen den benachbarten radialen Abschirmblechen 48 zu den benachbarten Montageplätzen abschirmt. Auch die Abschirmbleche 48 und die Abschirmwandanordnungen 50 sind als Module ausgestaltet und sie können - je nach Anordnung der übrigen Behandlungs-/Beschichtungskomponenten an unterschiedlichen Stellen im Inneres der Beschichtungskammer montiert werden.

Mit dem vorstehend beschriebenen Aufbau der Beschichtungsanlage ergibt sich folgender Effekt:
Nicht nur die Substratträger 2, sondern auch die Beschichtungs- und/oder Behandlungseinheiten 12, wie z.B. die Verdampferquellen, Kathoden, Targets, Magnetrons, Filamentkathode(n) und die Ätzanode sowie die Heizmodule 14 können modular zusammengestellt und derart angeordnet werden, dass die in einer Charge in die Anlage eingebrachten Substratkomponenten in der Beschichtungs- und Behandlungskammer einer unterschiedlichen Behandlung (Beschichtung, Oberflächenbehandlung) unterzogen werden können. Im Einzelnen können die Substratkomponenten, wie z.B. unterschiedliche Bohrwerkzeuge, die auf unterschiedlichen Substratträgern zusammengefasst sind, der unterschiedlichen Behandlung an verschiedenen Orten in der Abscheidungs- bzw. -behandlungskammer unterzogen werden, wobei über die Abschirmbleche 48 und die Abschirmwandanordnung 50 zumindest die auf einem Substratträger 26 angeordneten Substratkomponenten 56 ausschließlich im Einflussbereich einer ganz bestimmten Beschichtungs- und/oder Behandlungseinheit 12 gehalten werden.

Weil darüber hinaus eine Antriebsvorrichtung vorgesehen ist, mit der die Relativlage zwischen den Substratträgern 26 und den Beschichtungs- und/oder Behandlungseinheiten 12 bei geschlossener Abscheidungs- bzw. behandlungskammer veränderbar ist, ergibt sich die Möglichkeit, die Beschichtungsanlage selbst dann, wenn jeweils nur wenige Substratkomponenten mit einer spezifischen Beschichtung versehen oder einer spezifischen Behandlung unterzogen werden müssen, wirtschaftlich zu betreiben. Denn es können die Beschichtungs- und/oder Behandlungseinheiten 12, wie z.B. Verdampfer, Kathoden, Targets, Magnetrons, Filamentkathode und Ätzanode sowie die Abschirmelemente 48, 50 aus Modulen in der Abscheidungs- bzw. behandlungskammer entsprechend einem gewünschten Beschichtungs- bzw. Behandlungsprogramm für die Substratkomponenten zusammengestellt werden und dementsprechend die Substratträger 26 mit denjenigen Substratkomponenten bestückt werden, die derselben Behandlung unterzogen werden sollen. Anschließend kann die Abscheidungs- bzw. behandlungskammer geschlossen werden, woraufhin die individuellen Behandlungs- bzw. Beschichtungsprogramme für die in Gruppen auf den Substratträgern (26) zusammengefassten Substratkomponenten in einer Charge durchlaufen werden können. Ein mehrfaches Aufheizen und Abkühlen der Substratkomponenten und Substratträger kann entfallen, wodurch Prozesszeit in erheblichem Umfang eingespart und die Auslastung der Beschichtungsanlage auch bei kleinen Chargen stark gesteigert werden kann.

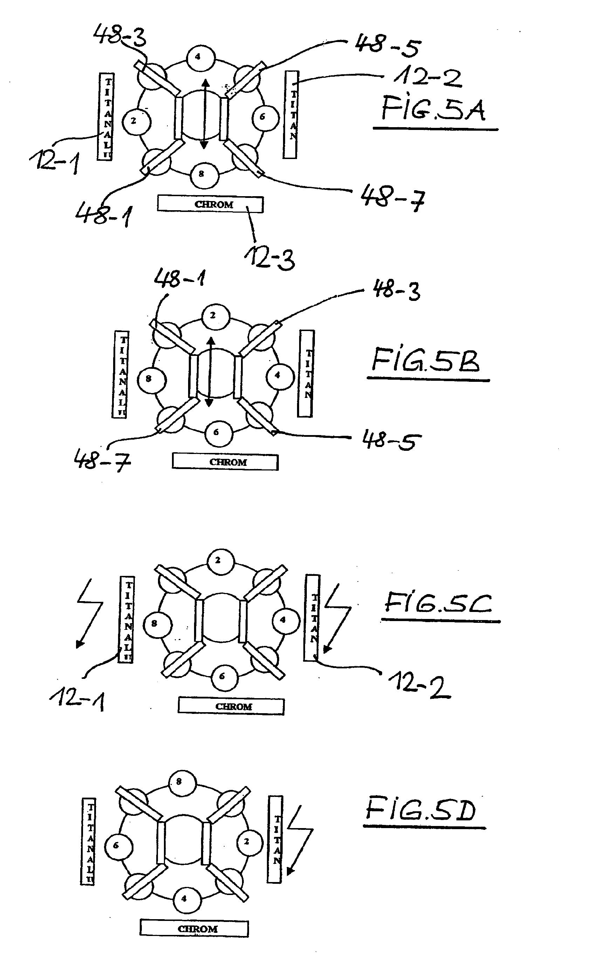

Dies soll anhand eines Behandlungsbeispiels anhand der Figuren 5A bis 5D erläutert werden:
Es sei z.B. angenommen, dass in einer Charge drei verschiedene Schichtarten aufgebracht werden sollen. In diesem Fall werden - wie in Figur 5A gezeigt - die Positionen 1,3.5 und 7 werden mit Abschottmodulen 48-1, 48-3, 48-5 und 48-7 besetzt. Auf den Positionen 2,4,6 und 8 werden Substrate chargiert.

Die Prozessphasen Pumpen, Heizen und Abkühlen sind für alle Substratträger gleich, der Montagetisch 10 bzw. das Karussell rotiert um seine Achse.

Zum Ätzen (Ionenätzen) stoppt das Karussell 10 und die Substratträger 26 an den Positionen 4 und 8 rotieren um ihre eigene Achse. Die Ätzphase kann beginnen (Figur 5A).

Sobald das Ätzen für Position 4 und 8 abgeschlossen ist, taktet der Antrieb weiter und Position 2 und 6 werden in die Ätzposition gebracht (Figur 5B). Nun drehen Position 6 und 2 um die eigene Achse, bis der Ionen-Beschuss abgeschlossen ist.

Wenn die Ätzphase erfolgreich abgeschlossen ist, beginnt das Beschichten (Figur 5C). DiePositionen 4 und 8 rotieren um die eigene Achse, und der diesen Positionen jeweils zugeordnete rechte und der linke Verdampfer mit den Targets TiAl und Ti werden gezündet, wobei - soweit vorhanden - nach erfolgtem Freibrennen (wenn möglich), ein nicht näher gezeigter Shutter geöffnet wird. Position 4 wird - nach Aufbauen einer geeigneten Stickstoff-Atmosphäre - mit Titannitrid und Position 8 mit Titanaluminiumnitrid beschichtet. Je nach erreichter Schichtdicke werden die Verdampfer abgeschaltet und/ oder der zugehörige Shutter geschlossen. Der Antrieb taktet weiter in die Position gemäß Figur 5D.

Jetzt können Positionen 2 und 6 mit einem nano-Layer beschichtet werden. Erreichen die Position 2 und 6 den jeweils für die nächste Lage notwendigen Verdampfer zündet der entsprechende Verdampfer und/oder der Shutter -wenn vorhanden - öffnet sich. Die jeweilige Lage kann abgeschieden werden. Die Position rotiert dann wieder um ihre eigene Achse.

Es kann jede Position einzeln oder auch gleichzeitig von verschiedenen Verdampfern beschichtet werden.

Um weiterzutakten rotiert das Karussell um die eigene Achse. Sind alle Layer abgeschieden, werden die Verdampfer abgeschaltet. Die gesamte Charge wird jetzt abgekühlt, woraufhin die Beschichtungs- bzw. Behandlungskammer, d.h. der Kessel belüftet werden kann. Der Prozess ist abgeschlossen.

Dieser vorstehend beschriebene Prozess ist nur eine mögliche Variante. Je nach vorhandener Verdampferanzahl und deren Targetmaterialien, Anzahl der Positionen und abhängig von Aufbau der Abschottmodule sind verschieden viele Schichtarten in einem Prozess möglich. Auch der Füllgrad ist unmittelbar von erwähnten Bedingungen abhängig und damit variierbar. Durch den modularen Aufbau sind auch eingekürzte Prozesse möglich. Hierbei wird nur eine verminderte Anzahl Positionen chargiert und diese gezielt geheizt, vorbehandelt und beschichtet.

Selbstverständlich sind Abweichungen von der vorstehend beschriebenen Ausführungsform möglich, ohne den Grundgedanken zu verlassen. So können selbstverständlich auch andere Schichten, beispielsweise dekorative Schichten abgeschieden werden.

Anstelle der an den Montageplätzen positionierbaren Abschottmodule können auch Abschotteinrichtungen zur Anwendung kommen, die entweder radial oder axial in den Innenraum der Behandlungskammer eingeschoben, und oder verfahren und/oder aufgerichtet werden.

Ferner kann beispielsweise im Bereich des Antriebs für die Substratträger eine kinematische Umkehr erfolgen, so dass der Montagetisch stationär bleibt und die Behandlungs-/Beschichtungseinheiten angetrieben werden.

Anstelle der Ätzanode können auch andere Funktionseinheiten zur Vorbehandlung des Substrats in der Beschichtungskammer verwendet werden, wobei auch die räumliche Anordnung dieser Funktionseinheiten, beispielsweise prozessbedingt, in weiten Grenzen variieren kann.

Schließlich kann auch die Antriebskinematik zur Bereitstellung der erforderlichen Relativbewegungen zwischen den Substratkomponenten und den Beschichtungs- bzw. Behandlungseinheiten frei variiert werden. Entscheidend ist allein, dass der Antrieb in der Lage ist, den Montagetisch, den Substratträger und vorteilhafter Weise auch die Halter für die einzelnen Substratkomponenten einer Relativ-Drehbewegung bezüglich der Behandlungseinheiten zu unterwerfen.

Mit der beschriebenen Anordnung lässt sich auch eine Betrieb realisieren, wie er mit herkömmlichen Anlagen möglich ist. Dann tragen alle Positionen Substrate. Es sind dann aber keine Abschottmodule 48, 50 eingebaut Alle in der Charge befindlichen Substrate werden in den verschiedenen Prozessphasen vergleichbar behandelt. Es wird nur eine Schichtart abgeschieden.

Eine weitere Möglichkeit des Betriebs besteht darin, dass der Beschichtungsprozess verkürzt wird, indem nur ausgewählte Substratträger bestückt und somit die Anlage nur mit einer Mindermenge chargiert wird und bei der Behandlung nur derjenige Sektor aufgeheizt wird, in dem eine Behandlung oder Beschichtung vorgenommen werden soll.

Die Erfindung schafft somit eine Vorrichtung zur Oberflächenbehandlung und/oder -beschichtung von Substratkomponenten durch Abscheidung aus der Gasphase, insbesondere durch physikalische Abscheidung aus der Gasphase nach dem PVD (Physical Vapour Deposition)- oder dem reaktiven PVD-Verfahren. In einer evakuierbaren Abscheidungs- bzw. behandlungskammer sind mehrere Substratträger und mehrere Beschichtungs- und/oder Behandlungseinheiten, wie z.B. Verdampferquellen, Kathoden, Targets, Magnetrons, Filamentkathode und Ätzanode angeordnet. Zur besseren wirtschaftlichen Auslastung der Anlage ist diese derart modular bestückbar, dass die in einer Charge in die Anlage eingebrachten Substratkomponenten einer unterschiedlichen Behandlung (Beschichtung, Oberflächenbehandlung) unterzogen werden können.

Die Erfindung stellt ferner ein neues Verfahren zur Oberflächenbehandlung und/oder -beschichtung von Substratkomponenten zur Verfügung, mit dem Beschichtungsanlagen nach dem PVD (Physical Vapour Deposition)- oder dem reaktiven PVD-Verfahren wesentlich wirtschaftlicher betrieben werden können. Es ist gekennzeichnet durch folgende Verfahrensschritte:
a) Zusammenstellen von Beschichtungs- und/oder Behandlungseinheiten (Verdampfer, Kathoden, Targets, Magnetrons, Filamentkathode und Ätzanode) sowie von Abschirmelementen aus Modulen in der Abscheidungs- bzw. behandlungskammer () entsprechend einem gewünschten Beschichtungs- bzw. Behandlungsprogramm für die Substratkomponenten;
b) Bestückung der Substratträger mit denjenigen Substratkomponenten, die derselben Behandlung unterzogen werden sollen;
c) Schließen der Abscheidungs- bzw. behandlungskammer; und
d) Durchlaufen der individuellen Behandlungs- bzw. Beschichtungsprogramme für die in Gruppen auf den Substratträgern zusammengefassten Substratkomponenten in einer Charge.

## Patentansprüche

1. Vorrichtung zur Oberflächenbehandlung und/oder -beschichtung von Substratkomponenten durch Abscheidung aus der Gasphase, insbesondere durch physikalische Abscheidung aus der Gasphase nach dem PVD (Physical Vapour Deposition)- oder dem reaktiven PVD-Verfahren, mit einer evakuierbaren Abscheidungs- bzw. behandlungskammer, in der mehrere drehbar antreibbare Substratträger (26) und mehrere Beschichtungs- und/oder Behandlungseinheiten (12, 14, 16) angeordnet sind, **gekennzeichnet durch** eine modulare Bestückbarkeit der Anlage derart, dass die in einer Charge in die Anlage eingebrachten Substratkomponenten (56) an verschiedenen Orten (Positionen 1 bis 8) in der Abscheidungs- bzw. -behandlungskammer einer unterschiedlichen Behandlung unterzogen werden können.

2. Vorrichtung nach Anspruch 1, **dadurch gekennzeichnet, dass** in der Abscheidungs- bzw. behandlungskammer zumindest eine Abschirmeinrichtung (48, 50, 52, 54) aufnehmbar ist, mit der zumindest die auf einem Substratträger (24, 26) angeordneten Substratkomponenten (56) ausschließlich im Einflussbereich einer Beschichtungs- und/oder Behandlungseinheit (12) gehalten werden.

3. Vorrichtung nach Anspruch 2, **dadurch gekennzeichnet, dass** die Abschirmeinrichtung (48, 50, 52, 54) als Modul ausgebildet und vorzugsweise von einer aus flächigen Komponenten, wie z.B. Blechen (48, 52, 54) zusammenstellbaren Trennwandkonfiguration (48, 50) gebildet ist.

4. Vorrichtung nach einem der Ansprüche 1 bis 3, **gekennzeichnet durch** eine Einrichtung (10, 32 bis 42), mit der die Relativlage zwischen den Substratträgern (24, 26) und den Beschichtungs- und/oder Behandlungseinheiten (12) bei geschlossener Abscheidungs- bzw. behandlungskammer veränderbar ist.

5. Vorrichtung nach Anspruch 4, **gekennzeichnet durch** einen in der Abscheidungs- bzw. Behandlungskammer radial innerhalb einer Trägerkonstruktion für die Beschichtungs- und/oder Behandlungseinheiten (12,14) aufgenommenen Montagetisch (10), der über seinen Umfang verteilt eine Vielzahl von mit einer Antriebquelle (22) für die Substratträger (24, 26) ausgestatteten Montageplätzen (18- 1 bis 18-8) aufweist.

6. Vorrichtung nach Anspruch 5, **dadurch gekennzeichnet, dass** die Montageplätze mit Substratträgern (24, 24) und/oder Abschirmeinrichtungen (48, 50) bestückbar sind.

7. Vorrichtung nach Anspruch 5 oder 6, **gekennzeichnet durch** eine Antriebs- und Indexiereinrichtung (10, 32 bis 42), mit der eine Relativ-Drehbewegung zwischen Montagetisch (10) und Trägerkonstruktion steuerbar ist.

8. Vorrichtung nach Anspruch 7, **dadurch gekennzeichnet, dass** der Montagetisch (10) einen Drehantrieb hat.

9. Vorrichtung nach einem der Ansprüche 5 bis 8, dass gekennzeichnet, dass der Antrieb der Substratträger (24, 26) auf die Substratkomponenten (56) abgeleitet wird.

10. Vorrichtung nach einem der Ansprüche 5 bis 9, **dadurch gekennzeichnet, dass** die Drehbewegung zumindest eines Substratträgers () von der Taktbewegung des Montagetischs entkoppelt ist.

11. Vorrichtung nach einem der Ansprüche 1 bis 10, **dadurch gekennzeichnet, dass** zumindest ausgewählte Beschichtungs- und/oder Behandlungseinheiten (12-1, 12-2) synchron betreibbar sind.

12. Vorrichtung nach einem der Ansprüche 5 bis 11, **dadurch gekennzeichnet, dass** die Trägerkonstruktion mit Montagestellen für die Beschichtungs- und/oder Behandlungseinheiten (12) und/oder Heizeinrichtungen (14) ausgestattet ist.

13. Verfahren zur Oberflächenbehandlung und/oder -beschichtung von Substratkomponenten mittels Abscheidung aus der Gasphase, insbesondere mittels physikalischer Abscheidung aus der Gasphase nach dem PVD (Physical Vapour Deposition)- oder dem reaktiven PVD-Verfahren, bei dem die Substratkomponenten zusammen mit mehreren drehbar antreibbaren Substratträgern in einer evakuierbaren Abscheidungs- bzw. behandlungskammer untergebracht sind, **gekennzeichnet durch** folgende Verfahrensschritte:
a) Zusammenstellen von Beschichtungs- und/oder Behandlungseinheiten (12,14) und/oder Heinzeinheiten (16) sowie von Abschirmelementen (48, 50) aus Modulen in der Abscheidungs- bzw. behandlungskammer entsprechend einem gewünschten Beschichtungs- bzw. Behandlungsprogramm für unterschiedliche Substratkomponenten (56);
b) Bestückung der einzelnen Substratträger (26) mit denjenigen Substratkomponenten (56), die derselben Behandlung unterzogen werden sollen;
c) Schließen der Abscheidungs- bzw. behandlungskammer; und
d) Durchlaufen der individuellen Behandlungs- bzw. Beschichtungsprogramme für die in Gruppen auf den Substratträgern (24, 26) zusammengefassten Substratkomponenten (56) in einer Charge.

14. Verfahren nach Anspruch 13, **dadurch gekennzeichnet, dass** im Verfahrensschritt d) die einzelnen Substratträger (24, 26) bei Bedarf getaktet in die für die jeweilige Oberflächenbehandlung optimierte Relativposition zur jeweils zugeordneten Beschichtungs- und/oder Behandlungseinheit (12) gebracht werden.

## Claims

1. A device for the surface treatment and/or coating of substrate components by deposition from the gas phase, in particular by physical deposition from the gas phase according to the PVD (physical vapor deposition) or the reactive PVD method, having a deposition or treatment chamber which can be evacuated, and in which multiple substrate carriers (26) and multiple coating and/or treatment units (12, 14, 16) (vaporizer sources, cathodes, targets, magnetrons, heating units, filament cathode, and etching anode) are situated rotatably drivable, **characterized by** an ability to equip the facility modularly in such a way that the substrate components (56) introduced in one batch into the facility at various locations (positions 1 to 8) within said deposition or treatment chamber can be subjected to different treatments (coating, surface treatment).

2. The device according to Claim 1, **characterized in that** at least one shielding unit (48, 50, 52, 54) can be received in the deposition or treatment chamber, using which at least the substrate components (56) which are situated on one substrate carrier (24, 26) are kept exclusively in the influence area of a coating and/or treatment unit (12).

3. The device according to Claim 2, **characterized in that** the shielding unit (48, 50, 52, 54) is implemented as a module and is preferably formed from planar components, such as a partition wall configuration (48, 50) which can be assembled from plates (48, 52, 54).

4. The device according to one of Claims 1 to 3, **characterized by** a unit (10, 32 to 42), using which the relative location between the substrate carriers (24, 26) and the coating and/or treatment units (12) is changeable when the deposition or treatment chamber is closed.

5. The device according to Claim 4, **characterized by** an installation table (10), which is received in the deposition or treatment chamber radially inside a carrier construction for the coating and/or treatment units (12, 14, vaporizer sources, cathodes, targets, magnetrons), and which has a plurality of installation spaces (18-1 to 18-8), which are equipped with a drive source (22) for the substrate carriers (24, 26), distributed over its circumference.

6. The device according to Claim 5, **characterized in that** the installation spaces can be equipped with substrate carriers (24, 24) and/or shielding units (48, 50).

7. The device according to Claim 5 or 6, **characterized by** a drive and indexing unit (10, 32 to 42), using which a relative rotational movement between installation table (10) and carrier construction is controllable.

8. The device according to Claim 7, **characterized in that** the installation table (10) has a rotary drive.

9. The device according to one of Claims 5 to 8, **characterized in that** the drive of the substrate carriers (24, 26) is discharged onto the substrate components (56).

10. The device according to one of Claims 5 to 9, **characterized in that** the rotational movement of at least one substrate carrier is decoupled from the cyclic movement of the installation table.

11. The device according to one of Claims 1 to 10, **characterized in that** at least selected coating and/or treatment units (12-1, 12-2) are operable synchronously.

12. The device according to one of Claims 5 to 11, **characterized in that** the carrier construction is equipped with installation positions for the coating and/or treatment units (12) and/or heating units (14).

13. A method for the surface treatment and/or coating of substrate components using deposition from the gas phase, in particular using physical deposition from the gas phase according to the PVD (physical vapor deposition) or the reactive PVD method, in which the substrate components are housed together with multiple rotatably drivable substrate carriers in a deposition or treatment chamber which can be evacuated, **characterized by** the following method steps:
a) assembling coating and/or treatment units (12, vaporizers, cathodes, targets, magnetrons, filament cathode, and etching anode) and/or heating units (16) as well as shielding elements (48, 50) from modules in the deposition or treatment chamber according to a desired coating or treatment program for different substrate components (56);
b) equipping the individual substrate carriers (26) with those substrate components (56) which are to be subjected to the same treatment;
c) closing the deposition or treatment chamber; and
d) executing the individual treatment or coating programs for the substrate components (56) assembled on the substrate carriers (24, 26) in one batch.

14. The method according to Claim 13, **characterized in that**, in method step d), the individual substrate carriers (24, 26) are brought as needed in a cyclic manner into the relative position which is optimized for the respective surface treatment for the respective associated coating and/or treatment unit (12).

## Revendications

1. Installation pour le traitement et/ou le revêtement de surface de composants de substrat par dépôt en phase gazeuse, en particulier par dépôt physique en phase gazeuse suivant le procédé PVD (Physical Vapour Deposition) - ou le procédé PVD réactif, avec une chambre de dépôt ou de traitement pouvant être mise sous vide, où sont disposés plusieurs supports de substrat (26) entraînables en rotation et plusieurs unités de revêtement et/ou de traitement (12, 14, 16), **caractérisée par** un équipement modulaire de l'installation, permettant de soumettre à des traitements différenciés, à plusieurs emplacements (positions 1 à 8) dans la chambre de dépôt ou de traitement, les composants de substrat (56) introduits en une charge dans l'installation.

2. Installation selon la revendication 1, **caractérisée en ce qu'**au moins un dispositif d'isolation (48, 50, 52, 54) peut être mis en place dans la chambre de dépôt ou de traitement, au moyen duquel au moins les composants de substrat (56) disposés sur un support de substrat (24, 26) sont maintenus exclusivement dans la zone d'influence d'une unité de revêtement et/ou de traitement (12).

3. Installation selon la revendication 2, **caractérisée en ce que** le dispositif d'isolation (48, 50, 52, 54) est réalisé comme module et est préférentiellement constitué par une configuration de paroi de séparation (48, 50) pouvant être assemblée à partir de composants plats, tels que des tôles (48, 52, 54).

4. Installation selon l'une des revendications 1 à 3, **caractérisée par** un dispositif (10, 32 à 42) permettant de modifier la position relative entre les supports de substrat (24, 26) et les unités de revêtement et/ou de traitement (12) quand la chambre de dépôt ou de traitement est fermée.

5. Installation selon la revendication 4, **caractérisée par** une table de montage (10) mise en place dans la chambre de dépôt ou de traitement radialement à l'intérieur d'une construction support pour les unités de revêtement et/ou de traitement (12, 14), laquelle comporte une pluralité d'emplacements de montage (18-1 à 18-8) répartis sur sa circonférence et pourvus d'une source d'entraînement (22) pour les supports de substrat (24, 26).

6. Installation selon la revendication 5, **caractérisée en ce que** les emplacements de montage peuvent être équipés de supports de substrat (24, 24) et/ou de dispositifs d'isolation (48, 50).

7. Installation selon la revendication 5 ou 6, **caractérisée par** un dispositif d'entraînement et d'indexation (10, 32 à 42), au moyen duquel un mouvement de rotation relative peut être commandé entre la table de montage (10) et la construction support.

8. Installation selon la revendication 7, **caractérisée en ce que** la table de montage (10) est pourvue d'un entraînement rotatif.

9. Installation selon l'une des revendications 5 à 8, **caractérisée en ce que** l'entraînement des supports de substrat (24, 26) est dérivé vers les composants de substrat (56).

10. Installation selon l'une des revendications 5 à 9, **caractérisée en ce que** le mouvement de rotation d'au moins un support de substrat (24, 26) est désolidarisé du mouvement cyclique de la table de montage.

11. Installation selon l'une des revendications 1 à 10, **caractérisée en ce qu'**au moins des unités de revêtement et/ou de traitement (12-1, 12-2) sélectionnées peuvent être mises en service de manière synchrone.

12. Installation selon l'une des revendications 5 à 11, **caractérisée en ce que** la construction support est pourvue de postes de montage pour les unités de revêtement et/ou de traitement (12) et/ou de dispositifs de chauffage (14).

13. Procédé traitement et/ou le revêtement de surface de composants de substrat par dépôt en phase gazeuse, en particulier par dépôt physique en phase gazeuse suivant le procédé PVD (Physical Vapour Deposition) - ou le procédé PVD réactif, où les composants de substrat sont introduits avec plusieurs supports de substrat entraînables en rotation dans une chambre de dépôt ou de traitement pouvant être mise sous vide, **caractérisé par** les étapes suivantes :
a) assemblage d'unités de revêtement et/ou de traitement (12, 14) et/ou d'unités de chauffage (16) ainsi que d'éléments d'isolation (48, 50) à partir de modules dans la chambre de dépôt ou de traitement en fonction d'un programme de revêtement ou de traitement souhaité pour différents composants de substrat (56) ;
b) équipement des supports de substrat (26) avec les composants de substrat (56) devant être soumis au même traitement ;
c) fermeture de la chambre de dépôt ou de traitement ; et
d) déroulement des programmes individuels de traitement ou de revêtement pour les composants de substrat (56) réunis en groupes sur les supports de substrat (24, 26) en une charge.

14. Procédé selon la revendication 13, **caractérisé en ce que** à l'étape d), les différents supports de substrat (24, 26) sont, si besoin, cycliquement amenés dans la position relative optimisée pour le traitement de surface correspondant vers l'unité de revêtement et/ou de traitement (12) associée.
